# EUROPEAN PATENT SPECIFICATION

(11) **EP 2 782 434 B1**
(45) Date of publication and mention of the grant of the patent: **31.07.2019**
(21) Application number: 13160374.8
(22) Date of filing: 21.03.2013
(51) Int. Cl.: H05K 7/20, H05K 5/06

(54) **Subsea unit comprising a subunit with an electronic or electric device**
Unterwassereinheit mit einer Unterwassereinheit mit einer elektronischen oder elektrischen Vorrichtung
Unité sous-marine comprenant une sous-unité avec un dispositif électronique ou électrique

(43) Date of publication of application: 24.09.2014
(73) Proprietor: ABB Schweiz AG, 5400 Baden (CH)
(72) Inventor: Piasecki, Wojciech, 30-009 KRAKOW (PL); Wiik, Jan, 0575 Oslo (NO); Kolstad, Helge, 0586 Oslo (NO); Spindler, Christian, 8707 Uetikon am See (CH)
(74) Representative: Savela, Reino Aleksi

(56) References cited:
- US-A1- 2012 291 688

## Description

### TECHNICAL FIELD

The present disclosure generally relates to subsea installations and in particular to a subsea unit comprising a subunit with an electronic or electric device arranged within the subunit.

### BACKGROUND

Various machinery such as pumps and compressors are employed in subsea production of oil and gas. Such machinery is driven by electric motors. Frequency converters in the medium voltage and power range drive electric motors by controlling the speed and torque of these machines and are a well proven equipment in the entire onshore and offshore platform based industry.

In recent years, there has been a growing interest in electrical installations on the sea floor in depths from a few tens of meters to even kilometres. In bringing power electronics subsea, two general concepts exist: (1) the equipment stays at atmospheric pressure; and (2) the equipment is pressurized to the hydrostatic pressure level on sea ground. The two concepts can be differentiated as follows. Concept (1) has the advantage that standard electric/electronic components, known from onshore installations, can be used, while disadvantages include thick walls needed for the enclosure to withstand the pressure difference between inside and outside. Thick walls make the equipment heavy and costly and prevent efficient cooling of the internal electric and electronic devices and sets high requirements on seals and penetrators. Concept (2) has the advantage that no thick walls are needed for the enclosure since no or only a relatively small pressure difference exists between inside and outside the containment.

US2010/0208415 discloses a subsea electric device able to withstand a high pressure environment according to concept (2). The device has a lightweight casing and is filled with a fluid such that the difference between the ambient pressure and interior pressure may be reduced. Electronic components inside the device casing also have casings which are entirely filled with an electrically insulating fluid. Each casing of electronic components comprises a volume compensation unit enabling the casing to adapt to various volumes dependent on the pressure. According to one embodiment, the volume compensation unit is a valve equipped with a filter for keeping pollution apart from the electronic components.

However, compensation units and electronic components degrade with time and in the long term affect the performance of subsea equipment.

US 2012/291688 A1 discloses a system for pressure compensation, e.g. for pressure compensation in a subsea environment. The system includes a fluid filled enclosure surrounding a cavity, a first pressure compensator having a first chamber and a second chamber, the first chamber being in fluid communication with the cavity, and a second pressure compensator having a third chamber and a fourth chamber, wherein the third chamber of the second pressure compensator is in fluid communication with the second chamber of the first pressure compensator.

### SUMMARY

In view of the above, a general object of the present disclosure is to provide a subsea unit that solves or at least mitigates the problems of the prior art. Hence, according to a first aspect of the present disclosure there is provided a subsea unit comprising: an external housing; a passive pressure compensator arranged to reduce a pressure difference between ambient subsea pressure and pressure inside the external housing; a subsea unit liquid for counteracting deformation of the external housing; and a first subunit arranged inside the external housing, and which first subunit comprises: a subunit housing, a passive pressure compensator arranged to reduce a pressure difference between the pressure inside the subunit housing and the pressure inside the external housing, a first electronic or electric device arranged inside the subunit housing, a first type of liquid for counteracting deformation of the subunit housing, and an absorber arranged to absorb debris emitted by the first electronic or electric device, wherein the absorber comprises one of a silicone gel, active coal and magnetic material.

By a passive pressure compensator is meant a pressure compensator that does not rely on active control for achieving pressure compensation or equalisation. The pressure that is applied to the passive pressure compensator influences the passive pressure compensator such that pressure compensation may be obtained.

By means of the passive pressure compensator the robustness and lifetime of the subsea unit may be improved as a passive pressure compensator does not contain any active parts or components which may degrade with time. Moreover, the absorber may absorb pollutants such as water which has leaked into the first subunit, and chemicals, gasses, soot, polymeric debris, metallic debris such as ferromagnetic metals, paramagnetic metals and non-magnetic metals released or emitted by the first electronic or electric device and which accumulate inside the first subunit. The absorber may efficiently absorb pollutants such that they do not float around inside the first subunit and cause damage to the first electronic or electric device or any other electric or electronic component contained within the first subunit or within the subsea unit. Pollutants may for example cause an electronic or electric device to short circuit. To summarize, the long term performance of the subsea unit may be improved.

According to one embodiment the absorber is a coating arranged on an internal surface of the subunit housing. By coating the internal surface of the subunit housing the capacity of the absorber may be increased because the larger area the absorber occupies the greater the absorption capacity, all else being equal.

According to one embodiment an area of the internal surface which is coated with the absorber corresponds at least to an area of an entire internal surface of at least one wall of the subunit housing. Thus, a large portion of the internal surface may be coated to improve the absorption capacity of the absorber. Essentially the entire inner surface may be coated with the absorber in case a very large absorption capacity is desired. The size of the absorber may for example be adapted to the electronic/electric devices contained in the first subunit.

According to one embodiment the first subunit comprises a filter that prevents a pollutant to penetrate into or out of the first subunit. By means of a filter, liquid communication may be obtained between the subsea unit liquid contained within the external housing, and the first type of liquid contained in the first subunit. Convective heat exchange may thereby be obtained. Furthermore some pollutants may be allowed to pass through the filter such that these pollutants do not accumulate inside the first subunit while the remaining pollutants are either absorbed by the absorber or filtered out by the filter.

According to one embodiment the filter comprises a semi-permeable membrane with a pore size that allows the first type of liquid and the subsea unit liquid to penetrate into or out of the first subunit and prevents the pollutant to penetrate into or out of the first subunit. By means of the pore size and by means of proper selection of the membrane material, filtering of certain pollutants may be obtained.

According to one embodiment the first subunit comprises a bulk absorber arranged to absorb a pollutant in the first subunit. The absorption capacity in the first subunit may thereby be further increased.

According to one embodiment the first type of liquid is a dielectric liquid adapted to characteristics of the first electronic or electric device. Hence, the first type of liquid may be optimized for the specific function and type of the first electronic or electric device.

One embodiment comprises a second subunit arranged inside the external housing, and which second subunit comprises: a subunit housing, a passive pressure compensator arranged to reduce a pressure difference between the pressure inside the subunit housing and the pressure inside the external housing, a second electronic or electric device arranged inside the subunit housing, a second type of liquid for counteracting deformation of the subunit housing, wherein the second type of liquid is a dielectric liquid adapted to characteristics of the second electronic or electric device, and an absorber arranged to absorb debris emitted by the second electronic or electric device. By enclosing and distributing the electric and/or electronic devices in one or more subunit the possible negative impact of one electronic or electric device failure, leading to contaminations of the subunit liquid and possible failure of other electric and/or electronic devices, may be restricted to the subunit subjected to the failure. Failure of an electronic or electric device inside a subunit which affects the liquid inside the subunit will generally thus not affect liquid inside other subunits or the subsea unit liquid inside the external housing of the subsea unit.

According to one embodiment the subunit housing has a wall thickness that can withstand a pressure difference of at least 100 bar between the pressure inside the subunit housing and the pressure inside the external housing. The thick walls may make the first subunit explosion proof in case of an internal explosion and the passive pressure compensator allows for minor changes in volume, for example if the interior heats up and expands.

According to one embodiment the passive pressure compensator of the first subunit is defined by a wall of the subunit housing, wherein the wall has a thickness presenting such a mechanically flexibility that it can adjust to a pressure difference of 50 bar between the pressure inside the subunit housing and the pressure inside the external housing. Thus, one face of the subunit housing is thinner than the remaining walls thereof. In the event of an explosion inside the first subunit, the shock wave will be directed out of the relatively thin wall and thus equipment which is located in another direction outside of the subunit housing will be not much affected by the explosion.

According to one embodiment the passive pressure compensator of the first subunit and a wall of the subunit housing is defined by a portion of the external housing of the subsea unit, and wherein the portion of the external housing has a thickness presenting such a mechanically flexibility that it can adjust to a pressure difference of 50 bar between the pressure inside the subunit housing and ambient subsea pressure. The shock wave from an interior explosion is directed towards the sea water and thus the remaining equipment within the subsea unit may be saved.

According to one embodiment the absorber comprises one of a silicone gel, active coal and magnetic material. The absorbing material may be selected based on what type of pollutant absorption is desired.

According to one embodiment the bulk absorber comprises one of a silicone gel, active coal and magnetic material.

The subsea unit of the first aspect may beneficially be utilised as a component of a subsea power system. Thus, according to a second aspect of the present disclosure there is provided a subsea power system comprising a subsea unit according to the first aspect.

According to one embodiment the subsea power system is a power transmission system.

According to one embodiment the subsea power system is a power distribution system.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 is a schematic side view of a subsea unit for subsea installation;
Figs 2a-d are schematic side views of examples of subunits of a subsea unit;
Figs 3a-c are schematic side views of examples of subunits of a subsea unit; and
Fig. 4 is a schematic side view of a subsea unit for subsea installation.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

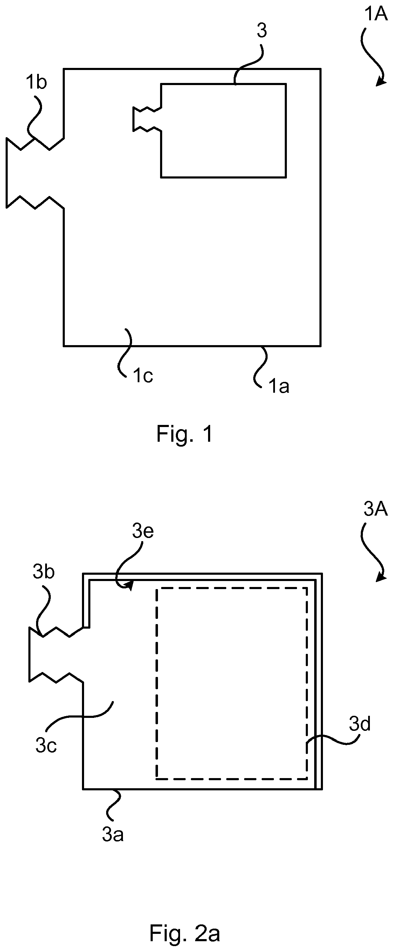

Fig. 1 schematically depicts a side view, with the external housing on the side cut-away, of a subsea unit for installation on the seabed. Subsea unit 1A has an external housing 1a, and comprises a passive pressure compensator 1b, a subsea unit liquid 1c and a first subunit 3. The subsea unit liquid 1c fills the entire interior space of the subsea unit 1A so as to prevent the occurrence of any air gaps between the inside surface of the external housing 1a and any internal component contained in the subsea unit 1A. The subsea unit liquid 1c counteracts deformation of the external housing 1a when the subsea unit 1A is subjected to an ambient subsea pressure higher than a pressure that the external housing 1a can withstand without deformation. The subsea unit liquid 1c is advantageously a dielectric liquid such as oil in order to prevent short circuit of any electronic or electric device contained in the subsea unit 1A.

The passive pressure compensator 1b is arranged to transmit ambient subsea pressure to the inside of the external housing 1a. Thereby a pressure difference between ambient subsea pressure and pressure inside the external housing 1a may be reduced. The passive pressure compensator 1b may for example be defined by a mechanically flexible portion of the external housing 1a, or a membrane such as an impermeable membrane. The interior volume of the subsea unit 1A and thus the pressure inside the external housing 1a is hence dependent of the ambient subsea pressure.

The first subunit 3 comprises a first type of liquid and one or more electric and/or electronic devices. The first subunit 3 is arranged inside the subsea unit 1A and is thus enclosed by the external housing 1a.

Examples of electronic devices are capacitors, for example capacitors based on metalized film technology or on oil-soaked film-foil technology, and power electronic devices such as insulated gate bipolar transistor (IGBT) modules, integrated gate-commutated thyristors (IGCT), diodes, and thyristors, while examples of electric devices are frequency converters and transformers, which in the former case include capacitors and power electronic devices such as IGBT modules.

Fig. 2a depicts a first example of a subunit 3, in the following referred to as first subunit 3A. The first subunit 3A comprises a subunit housing 3a, a passive pressure compensator 3b, a first type of liquid 3c, a first electronic or electric device 3d and an absorber 3e. It is to be noted that the first subunit 3 may comprise one or a plurality of electronic and/or electric devices either of the same type or a combination of different electronic and/or electric devices.

The passive pressure compensator 3b is arranged to reduce a pressure difference between the pressure inside the subunit housing 3a and the pressure inside the external housing 1a of the subsea unit 1A. The passive pressure compensator 3b may according to the example in Fig. 2a for example be defined by a mechanically flexible portion of the subunit housing 3a, or a membrane such as an impermeable membrane.

The first type of liquid fills the entire interior space of the first subunit 3A so as to prevent the occurrence of any air gaps between the inside surface of the subunit housing 3a and any internal component contained in the first subunit 3A and counteracts deformation of the subunit housing 3a when the first subunit 3A is subjected to an ambient subsea pressure higher than a pressure that the subunit housing 3a can withstand without deformation.

The absorber 3e is arranged to absorb a pollutant present in the first subunit 3A. Such a pollutant may for example be water or debris emitted by the first electronic or electric device 3d. Debris may be emitted by the electronic or electric device(s) in the first subunit 3A due to degradation of these devices. In addition to water, pollutants may for example include chemicals, gasses, soot, polymeric debris, metallic debris such as ferromagnetic metals, paramagnetic metals and non-magnetic metals.

Depending on what pollutant is to be absorbed, the absorber 3e may for example comprise silicon gel if water is to be absorbed for drying the first type of liquid 3c, a soot particle filter if soot is to be absorbed, an active coal absorber if polymeric or non-magnetic metal debris is to be absorbed, or magnetic material in case magnetic metal debris is to be absorbed.

It is envisaged that in one variation, the first subunit may comprise several different absorbers, each having a specific absorption function for absorbing a specific type of pollutant.

According to one variation, the absorber 3e is a coating arranged on an internal surface of the subunit housing 3a. The absorption capacity of the absorber 3e depends, *inter alia,* on its size, i.e. on the area which the absorber 3e occupies on the internal surface of the subunit housing 3a. The larger area the absorber occupies the greater the absorption capacity, all else being equal. The area of the internal surface which is coated with the absorber 3e may for example correspond at least to an area of an entire internal surface of at least one wall of the subunit housing 3a. The absorber may be comprised of several discontinuous parts distributed on the internal surface of the subunit housing 3a. Alternatively, the absorber may be comprised of a single piece in which case its extension is continuous and connected.

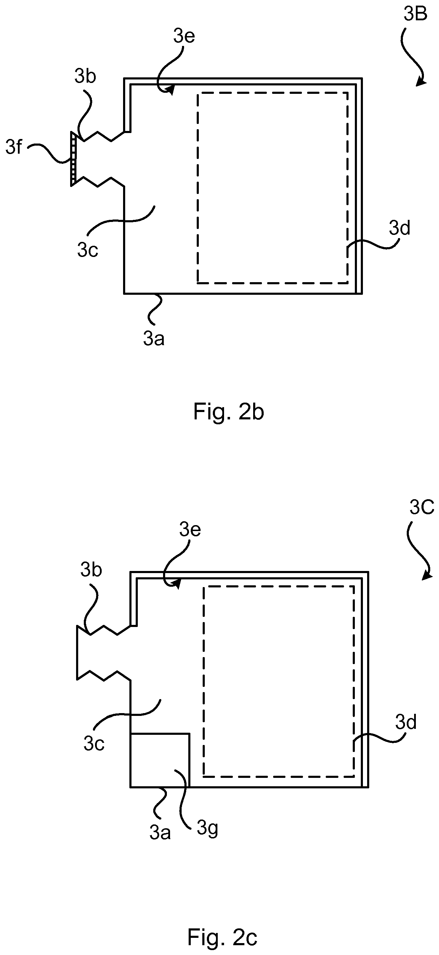

Fig. 2b schematically depicts a side view, with the external housing on the side cut-away, of a second example of a first subunit 3 in the following referred to as first subunit 3B. Structurally, the second example of the first subunit 3B is identical to the first subunit 3A of Fig. 2a, except that the first subunit 3b according to the second example comprises a filter 3f which acts as pressure compensator. The filter 3f hence defines the passive pressure compensator 3b of the first subunit 3B according to the second example. The filter 3f is arranged to prevent a pollutant such as debris to penetrate the filter 3f. The filter 3f hence prevents a pollutant to penetrate into or out of the first subunit 3B. Pollutants external to the first subunit 3B may hence be prevented from entering the first subunit 3B, and pollutants generated or released inside the first subunit 3B may be prevented from exiting the first subunit 3B. A pollutant released or emitted from the first electronic or electric device 3d may thereby be retained in first subunit 3B and is thus prevented to flow out from the first subunit 3B. According to one variation, the filter 3f comprises a semi-permeable membrane with a pore size that allows the first type of liquid 3c and the subsea unit liquid 1c to penetrate the filter 3f and prevents a pollutant such as debris to penetrate the filter 3f. Thus, if for example there is a higher pressure in the subsea unit 1A, 1B than in the subunit 3B the subsea unit liquid 1c may enter the subunit 3B through the filter 3f, and if there is a higher pressure in the subunit 3B than in the subsea unit 1A, 1B, the first type of liquid 3c may flow through the filter 3f from the subunit 3B and mix with the subsea unit liquid 1c in the subsea unit 1A, 1B outside the subunit 3B. Moreover, natural heat convection may be obtained for cooling the first electronic or electric device 3d.

Fig. 2c schematically depicts a side view, with the external housing on the side cut-away, of a third example of a first subunit 3 in the following referred to as first subunit 3C. Structurally, the third example of the first subunit 3C is identical to the first subunit 3A of Fig. 2a, except that the first subunit 3C according to the third example also comprises a bulk absorber 3g arranged to absorb a pollutant in the first subunit 3C. As discussed above, such a pollutant may for example be water, chemicals, gasses or debris emitted by the first electronic or electric device 3d, such as polymeric debris, metallic e.g. ferromagnetic metals, paramagnetic metals and non-magnetic metals.

Depending on what pollutant is to absorbed, the bulk absorber 3g may for example comprise a silicon gel e.g. a reservoir thereof if water is to be absorbed for drying the first type of liquid 3c, a soot particle filter if soot is to be absorbed, an active coal absorber if polymeric or non-magnetic metal debris is to be absorbed, or magnetic material in case magnetic metal debris is to be absorbed.

It is envisaged that in one variation, the first subunit may comprise several different bulk absorbers, each having a specific absorption function for absorbing a specific type of pollutant.

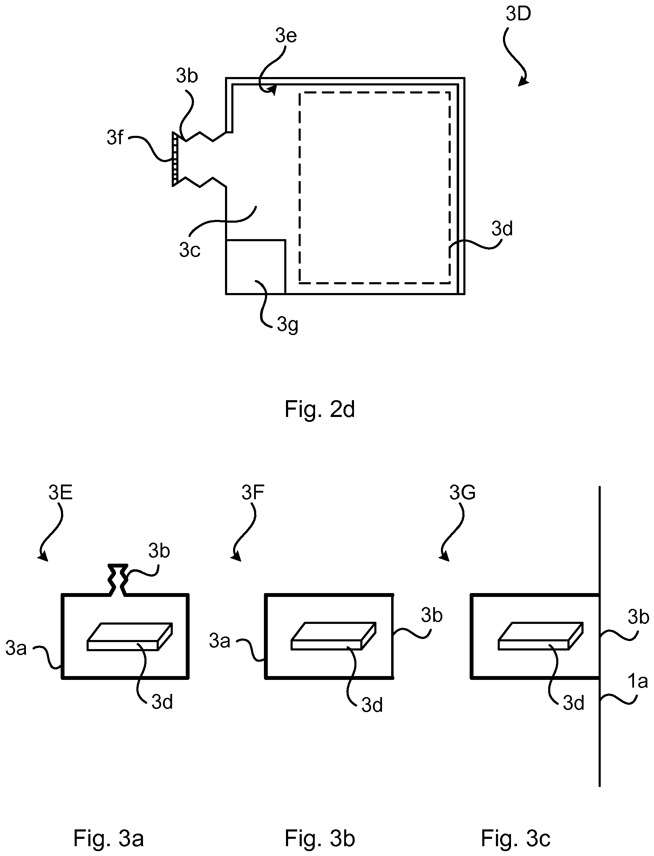

Fig. 2d schematically depicts a side view, with the external housing on the side cut-away, of a fourth example of a first subunit 3 in the following referred to as first subunit 3D. Structurally, the fourth example of the first subunit 3D is identical to the first subunit 3A of Fig. 2a, except that the first subunit 3D according to the fourth example comprises a filter 3f according to any variation described in the first subunit 3B of the second example, acting as passive pressure compensator, and one or more bulk absorbers 3g according to any variation described in the first subunit 3C of the third example. The first subunit 3D according to the fourth example hence comprises three different means for pollution retention, namely absorber 3e, filter 3f and bulk absorber 3g.

Figs 3a-c show further aspects of the first subunits 3A-D. In addition to the pollution retention aspect described above, any of the examples of the first subunit 3A-D may have a subunit housing structure as disclosed herebelow. In order to render the description clearer the means for pollution retention are not shown in the examples in Figs 3a-c.

Fig. 3a schematically depicts a side view, with the external housing on the side cut-away, of a first subunit 3E. Subunit 3E has a subunit housing 3a which has a wall thickness that can withstand a pressure difference of at least 100 bar between the pressure inside the subunit housing 3a and the pressure inside the external housing 1a of the subsea unit 1A, 1B. The thick walls make the subunit 3E explosion proof in case of an internal explosion. The passive pressure compensator 3b is small and only allows for minor changes in volume, for example if the interior heats up and expands.

Fig. 3b schematically depicts a side view, with the external housing on the side cut-away, of a first subunit 3F. The passive pressure compensator 3b of the first subsea unit 3F is defined by a wall of the subunit housing 3a. The wall has a thickness presenting such a mechanically flexibility that it can adjust to a pressure difference of 50 bar, preferably 20 bar, between the pressure inside the subunit housing 3a and the pressure inside the external housing 1a of subsea unit 1A, 1B. Thus, one face or a portion of a face of the subunit housing 3a is thinner than the remaining walls thereof. In the event of an explosion inside the subunit 3F, the shock wave will be directed out of the relatively thin wall and thus equipment which is located in another direction outside of the subunit housing 3a will be not much affected by the explosion.

Fig. 3c schematically depicts a side view, with the external housing on the side cut-away, of a first subunit 3G. According to this example, the passive pressure compensator is a wall of the subunit housing and is defined by a portion of the external housing 1a of the subsea unit 1A, 1B. A wall of the external housing 1a thus functions as a wall and passive pressure compensator for the first subunit 3G. The portion of the external housing 1a has a thickness presenting such a mechanically flexibility that it can adjust to a pressure difference of 50 bar, preferably 20 bar, between the pressure inside the subunit housing 3a and ambient subsea pressure. The shock wave from an interior explosion is directed towards the sea water and thus the remaining equipment within the subsea unit 1A, 1B may be saved.

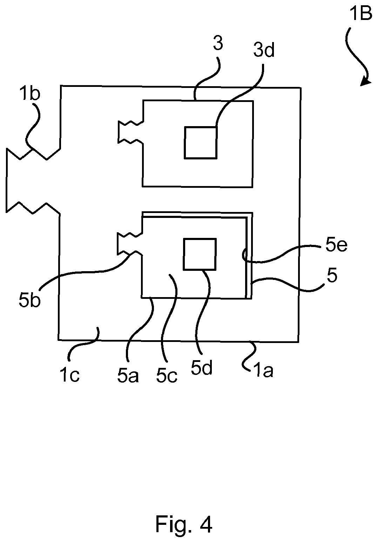

Fig. 4 depicts a subsea unit 1B which is structurally identical to subsea unit 1A except that it comprises a plurality of subunits, e.g. a first subunit generally denoted 3 which can be any of the first subunits 3A-G and a second subunit 5, within the external housing 1a. The first subunit 3 and the second subunit 5 may be identical, or they may be structurally and/or functionally different. The second subunit 5 comprises a subunit housing 5a, a passive pressure compensator 5b, a second electronic or electric device 5c and an absorber 5e. According to one variation the second electronic or electric device 5d is of a different type than the first electronic or electric device 3c in the first subunit 3. The second subunit 5 comprises a second type of liquid 5c for counteracting deformation of the subunit housing. The second type of liquid 5c is preferably a dielectric liquid adapted to characteristics of the second electronic or electric device 5c. The second type of liquid may be thus be optimized for the characteristics of the second electronic or electric devices 5c. If for example the second electronic or electric device 5c is a capacitor, the second type of liquid may be capacitor oil, and if the second subunit 5 comprises IGBTs the second type of liquid may be partial discharge optimized oil. The first type of liquid 3c may be a dielectric liquid adapted to characteristics of the first electronic or electric device 3c. Thus the first type of liquid 3c may be optimized for the characteristics of the first electronic or electric devices 3c. Further examples of the first type of liquid 3c and the second type of liquid 5c include water, silicone oil, mineral oil, and esters like Midel.

By enclosing and distributing the electric and/or electronic devices in one or more subunit the possible negative impact of one electronic or electric device failure, leading to contaminations of the subunit liquid and possible failure of other electric and/or electronic devices, may be restricted to the subunit subjected to the failure. Failure of an electronic or electric device inside a subunit which affects the liquid inside the subunit will generally thus not affect liquid inside other subunits or the subsea unit liquid inside the external housing 3 of the subsea unit 1B.

According to one variation, the type of electronic devices gathered in one subunit can represent one function or building block within a power electronic system. Failure of most electronic devices inside one subunit will result in failure of the specific function or change in operating mode. Therefore, according to one variation hereof, a subsea unit may comprise several subunits comprising the same electric and/or electronic devices having the same specific function. Redundancy may thereby be achieved.

It is envisaged that the subsea units presented herein find applications within the oil and gas industry for example for subsea HVDC/HVAC power transmission and power distribution systems, as well as offshore power generation such as wind energy, tidal energy, wave energy, and ocean current energy.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A subsea unit (1A; 1B) comprising:
an external housing (1a),
a passive pressure compensator (1b) arranged to reduce a pressure difference between ambient subsea pressure and pressure inside the external housing (1a),
a subsea unit liquid (1c) for counteracting deformation of the external housing (1a), and
a first subunit (3A; 3B; 3C; 3D; 3E; 3F; 3G) arranged inside the external housing (1a), and which first subunit (3A; 3B; 3C; 3D; 3E; 3F; 3G) comprises:
a subunit housing (3a),
a passive pressure compensator (3b) arranged to reduce a pressure difference between the pressure inside the subunit housing (3a) and the pressure inside the external housing (1a),
a first electronic or electric device (3d) arranged inside the subunit housing (3a),
a first type of liquid (3c) for counteracting deformation of the subunit housing (3a),
**characterised by** an absorber (3e) arranged to absorb a pollutant in the first subunit (3A; 3B; 3C; 3D; 3E; 3F; 3G), wherein the absorber (3e) comprises one of a silicone gel, active coal and magnetic material.

2. The subsea unit (1A; 1B) as claimed in claim 1, wherein the absorber (3e) is a coating arranged on an internal surface of the subunit housing (3a).

3. The subsea unit (1A; 1B) as claimed in claim 2, wherein an area of the internal surface which is coated with the absorber (3e) corresponds at least to an area of an entire internal surface of at least one wall of the subunit housing (3a).

4. The subsea unit (1A; 1B) as claimed in any of the preceding claims, wherein the first subunit (3B; 3D; 3E; 3F; 3G) comprises a filter (3f) that prevents a pollutant to penetrate into or out of the first subunit (3B; 3D; 3E; 3F; 3G).

5. The subsea unit (1A; 1B) as claimed in claim 4, wherein the filter (3f) comprises a semi-permeable membrane with a pore size that allows the first type of liquid (3c) and the subsea unit liquid (1c) to penetrate into or out of the first subunit (3B; 3D; 3E; 3F; 3G) and prevents the pollutant to penetrate into or out of the first subunit (3B; 3D; 3E; 3F; 3G).

6. The subsea unit (1A; 1B) as claimed in any of the preceding claims, wherein the first subunit (3B; 3D; 3E; 3F; 3G) comprises a bulk (3g) absorber arranged to absorb a pollutant in the first subunit (3B; 3D; 3E; 3F; 3G).

7. The subsea unit (1A; 1B) as claimed in any of the preceding claims, wherein the first type of liquid (1a) is a dielectric liquid adapted to characteristics of the first electronic or electric device (1d).

8. The subsea unit (1B) as claimed in any of the preceding claims, comprising a second subunit (5) arranged inside the external housing (1a), and which second subunit (5) comprises:
a subunit housing (5a),
a passive pressure compensator (5b) arranged to reduce a pressure difference between the pressure inside the subunit housing (5a) and the pressure inside the external housing (1a),
a second electronic or electric device (5d) arranged inside the subunit housing (5a),
a second type of liquid (5c) for counteracting deformation of the subunit housing (5a), wherein the second type of liquid (5c) is a dielectric liquid adapted to characteristics of the second electronic or electric device (5d), and
an absorber (5e) arranged to absorb a pollutant in the second subunit (5).

9. The subsea unit (1A; 1B) as claimed in any of the preceding claims, wherein the subunit housing (3a) has a wall thickness that can withstand a pressure difference of at least 100 bar between the pressure inside the subunit housing (3a) and the pressure inside the external housing (1a).

10. The subsea unit (1A; 1B) as claimed in any of the preceding claims, wherein the passive pressure compensator (3b) of the first subunit (3F) is defined by a wall of the subunit housing (3a), wherein the wall has a thickness presenting such a mechanically flexibility that it can adjust to a pressure difference of 50 bar between the pressure inside the subunit housing (3a) and the pressure inside the external housing (1a).

11. The subsea unit (1A; 1B) as claimed in any of the preceding claims, wherein the passive pressure compensator (3b) of the first subunit (3G) and a wall of the subunit housing (3a) is defined by a portion of the external housing (1a) of the subsea unit (1A; 1B), and wherein the portion of the external housing (1a) has a thickness presenting such a mechanically flexibility that it can adjust to a pressure difference of 50 bar between the pressure inside the subunit housing (3a) and ambient subsea pressure.

12. The subsea unit (1A; 1B) as claimed in any of claims 6-11 wherein the bulk absorber (3g) comprises one of a silicone gel, active coal and magnetic material.

13. A subsea power system comprising a subsea unit (1A; 1B) as claimed in any of claims 1-12.

14. The subsea power system as claimed in claim 13, wherein the subsea power system is a power transmission system or a power distribution system.

## Patentansprüche

1. Unterwassereinheit (1A, 1B) umfassend:
ein Außengehäuse (1a),
einen passiven Druckkompensator (1b), der geeignet ist zum Verringern einer Druckdifferenz zwischen einem Umgebungsunterwasserdruck und einem Druck innerhalb des Außengehäuses (1a),
eine Unterwassereinheitsflüssigkeit (1c) zum Entgegenwirken gegen Verformungen des Außengehäuses (1a), und
eine erste Teileinheit (3A; 3B; 3C; 3D; 3E; 3F; 3G), die innerhalb des Außengehäuses (1a) angeordnet ist, und wobei die erste Teileinheit (3A; 3B; 3C; 3D; 3E; 3F; 3G) umfasst:
ein Teileinheitsgehäuse (3a),
einen passiven Druckkompensator (3b), der geeignet ist zum Verringern einer Druckdifferenz zwischen dem Druck innerhalb des Teileinheitsgehäuses (3a) und dem Druck innerhalb des Außengehäuses (1a),
eine erste elektronische oder elektrische Vorrichtung (3d), die innerhalb des Teileinheitsgehäuses (3a) angeordnet ist,
einen ersten Flüssigkeitstyp (3c) zum Entgegenwirken gegen Verformungen des Teileinheitsgehäuses (3a), und
**dadurch gekennzeichnet, dass** ein Absorber (3e) geeignet ist zum Absorbieren eines Schadstoffes in der ersten Teileinheit (3A; 3B; 3C; 3D; 3E; 3F; 3G), wobei der Absorber (3e) eines von einem Siliziumgel, einer Aktivkohle oder eines magnetischen Materials umfasst.

2. Unterwassereinheit (1A; 1B) nach Anspruch 1, wobei der Absorber (3e) eine Beschichtung ist, die auf einer Innenseite des Teileinheitsgehäuses (3a) angeordnet ist.

3. Unterwassereinheit (1A, 1B) nach Anspruch 2, wobei ein Bereich der Innenseite, die mit dem Absorber (3e) beschichtet ist, mindestens einem Bereich einer gesamten Innenseite von mindestens einer Wand des Teileinheitsgehäuses (3a) entspricht.

4. Unterwassereinheit (1A; 1B) nach einem der vorhergehenden Ansprüche, wobei die erste Teileinheit (3B; 3D; 3E; 3F; 3G) einen Filter (3f) umfasst, der verhindert, dass ein Schadstoff in die erste Teileinheit (3B; 3D; 3E; 3F; 3G) eindringt oder sie verlässt.

5. Unterwassereinheit (1A; 1B) nach Anspruch 4, wobei der Filter (3f) eine semipermeable Membran mit einer Porengröße umfasst, die erlaubt, dass der erste Flüssigkeitstyp (3c) und die Unterwassereinheitsflüssigkeit (1c) in die erste Teileinheit (3B; 3D; 3E; 3F; 3G) eindringen oder sie verlassen, und verhindert, dass der Schadstoff in die erste Teileinheit (3B; 3D; 3E; 3F; 3G) eindringt oder sie verlässt.

6. Unterwassereinheit (1A; 1B) nach einem der vorhergehenden Ansprüche, wobei die erste Teileinheit (3B; 3D; 3E; 3F; 3G) einen Massenabsorber (3g) umfasst, der geeignet ist zum Absorbieren eines Schadstoffes in der ersten Teileinheit (3B; 3D; 3E; 3F; 3G).

7. Unterwassereinheit (1A; 1B) nach einem der vorhergehenden Ansprüche, wobei der erste Flüssigkeitstyp (1a) eine dielektrische Flüssigkeit ist, die für die Eigenschaften der ersten elektronischen oder elektrischen Vorrichtung (1d) ausgelegt ist.

8. Unterwassereinheit (1B) nach einem der vorhergehenden Ansprüche, die eine zweite Teileinheit (5) umfasst, die innerhalb des Außengehäuses (1a) angeordnet ist, und wobei die zweite Teileinheit (5) umfasst:
ein Teileinheitsgehäuse (5a),
einen passiven Druckkompensator (5b), der geeignet ist zum Verringern einer Druckdifferenz zwischen dem Druck innerhalb des Teileinheitsgehäuses (5a) und dem Druck innerhalb des Außengehäuses (1a),
eine zweite elektronische oder elektrische Vorrichtung (5d), die innerhalb des Teileinheitsgehäuses (5a) angeordnet ist,
einen zweiten Flüssigkeitstyp (5c) zum Entgegenwirken gegen Verformungen des Teileinheitsgehäuses (5a), wobei der zweite Flüssigkeitstyp (5c) eine dielektrische Flüssigkeit ist, die für die Eigenschaften der zweiten elektronischen oder elektrischen Vorrichtung (5d) ausgelegt ist, und
einen Absorber (5e), der geeignet ist zum Absorbieren eines Schadstoffes in der zweiten Teileinheit (5).

9. Unterwassereinheit (1A; 1B) nach einem der vorhergehenden Ansprüche, wobei das Teileinheitsgehäuse (3a) eine Wandstärke aufweist, die eine Druckdifferenz von mindestens 100 Bar zwischen dem Druck innerhalb des Teileinheitsgehäuses (3a) und dem Druck innerhalb des Außengehäuses (1a) aushalten kann.

10. Unterwassereinheit (1A; 1B) nach einem der vorhergehenden Ansprüche, wobei der passive Druckkompensator (3b) der ersten Teileinheit (3F) durch eine Wand des Teileinheitsgehäuses (3a) definiert wird, wobei die Wand eine Stärke aufweist, die eine solche mechanische Flexibilität präsentiert, dass sie eine Druckdifferenz von 50 Bar zwischen dem Druck innerhalb des Teileinheitsgehäuses (3a) und dem Druck innerhalb des Außengehäuses (1a) ausgleichen kann.

11. Unterwassereinheit (1A; 1B) nach einem der vorhergehenden Ansprüche, wobei der passive Druckkompensator (3b) der ersten Teileinheit (3G) und eine Wand des Teileinheitsgehäuses (3a) durch einen Abschnitt des Außengehäuses (1a) der Unterwassereinheit (1A; 1B) definiert werden, und wobei der Abschnitt des Außengehäuses (1a) eine Stärke aufweist, die eine solche mechanische Flexibilität präsentiert, dass sie eine Druckdifferenz von 50 Bar zwischen dem Druck innerhalb des Teileinheitsgehäuses (3a) und dem Umgebungsunterwasserdruck ausgleichen kann.

12. Unterwassereinheit (1A; 1B) nach einem der Ansprüche 6 bis 11, wobei der Massenabsorber (3g) eines von einem Siliziumgel, einer Aktivkohle oder eines magnetischen Materials umfasst.

13. Unterwasserstromversorgungssystem, das eine Unterwassereinheit (1A; 1B) nach einem der Ansprüche 1 bis 12 umfasst.

14. Unterwasserstromversorgungssystem nach Anspruch 13, wobei das Unterwasserstromversorgungssystem ein Stromübertragungssystem oder ein Stromverteilungssystem ist.

## Revendications

1. Unité sous-marine (1A; 1B) comportant :
un boîtier externe (1a),
un compensateur passif (1b) de pression disposé pour réduire une différence de pression entre une pression sous-marine ambiante et une pression à l'intérieur du boîtier externe (1a),
un liquide (1c) d'unité sous-marine servant à s'opposer à la déformation du boîtier externe (1a), et
une première sous-unité (3A; 3B; 3C; 3D; 3E; 3F; 3G) disposée à l'intérieur du boîtier externe (1a), ladite première sous-unité (3A; 3B; 3C; 3D; 3E; 3F; 3G) comportant :
un boîtier (3a) de sous-unité,
un compensateur passif (3b) de pression disposé pour réduire une différence de pression entre la pression à l'intérieur du boîtier (3a) de sous-unité et la pression à l'intérieur du boîtier externe (1a),
un premier dispositif électronique ou électrique (3d) disposée à l'intérieur du boîtier (3a) de sous-unité,
un premier type de liquide (3c) servant à s'opposer à la déformation du boîtier (3a) de sous-unité,
**caractérisée par** un absorbeur (3e) disposé pour absorber un polluant dans la première sous-unité (3A; 3B; 3C; 3D; 3E; 3F; 3G), l'absorbeur (3e) comportant un matériau parmi un gel de silicone, du charbon actif et un matériau magnétique.

2. Unité sous-marine (1A; 1B) selon la revendication 1, l'absorbeur (3e) étant un revêtement disposé sur une surface interne du boîtier (3a) de sous-unité.

3. Unité sous-marine (1A; 1B) selon la revendication 2, une aire de la surface interne qui est revêtue de l'absorbeur (3e) correspondant au moins à une aire d'une surface interne entière d'au moins une paroi du boîtier (3a) de sous-unité.

4. Unité sous-marine (1A; 1B) selon l'une quelconque des revendications précédentes, la première sous-unité (3B; 3D; 3E; 3F; 3G) comportant un filtre (3f) qui empêche un polluant de pénétrer vers l'intérieur ou l'extérieur de la première sous-unité (3B; 3D; 3E; 3F; 3G).

5. Unité sous-marine (1A; 1B) selon la revendication 4, le filtre (3f) comportant une membrane semi-perméable présentant une taille de pores qui permet au premier type de liquide (3c) et au liquide (1c) d'unité sous-marine de pénétrer vers l'intérieur ou l'extérieur de la première sous-unité (3B; 3D; 3E; 3F; 3G) et empêche le polluant de pénétrer vers l'intérieur ou l'extérieur de la première sous-unité (3B; 3D; 3E; 3F; 3G).

6. Unité sous-marine (1A; 1B) selon l'une quelconque des revendications précédentes, la première sous-unité (3B; 3D; 3E; 3F; 3G) comportant un absorbeur (3g) en vrac disposé pour absorber un polluant dans la première sous-unité (3B; 3D; 3E; 3F; 3G).

7. Unité sous-marine (1A; 1B) selon l'une quelconque des revendications précédentes, le premier type de liquide (1a) étant un liquide diélectrique adapté à des caractéristiques du premier dispositif électronique ou électrique (1d).

8. Unité sous-marine (1B) selon l'une quelconque des revendications précédentes, comportant une deuxième sous-unité (5) disposée à l'intérieur du boîtier externe (1a), ladite deuxième sous-unité (5) comportant :
un boîtier (5a) de sous-unité,
un compensateur passif (5b) de pression disposé pour réduire une différence de pression entre la pression à l'intérieur du boîtier (5a) de sous-unité et la pression à l'intérieur du boîtier externe (1a),
un deuxième dispositif électronique ou électrique (5d) disposé à l'intérieur du boîtier (5a) de sous-unité,
un deuxième type de liquide (5c) servant à s'opposer à la déformation du boîtier (5a) de sous-unité, le deuxième type de liquide (5c) étant un liquide diélectrique adapté à des caractéristiques du deuxième dispositif électronique ou électrique (5d), et
un absorbeur (5e) disposé pour absorber un polluant dans la deuxième sous-unité (5).

9. Unité sous-marine (1A; 1B) selon l'une quelconque des revendications précédentes, le boîtier (3a) de sous-unité présentant une épaisseur de paroi qui peut résister à une différence de pression d'au moins 100 bar entre la pression à l'intérieur du boîtier (3a) de sous-unité et la pression à l'intérieur du boîtier externe (1a).

10. Unité sous-marine (1A; 1B) selon l'une quelconque des revendications précédentes, le compensateur passif (3b) de pression de la première sous-unité (3F) étant défini par une paroi du boîtier (3a) de sous-unité, la paroi présentant une épaisseur dotée d'une flexibilité mécanique telle qu'elle peut s'adapter à une différence de pression de 50 bar entre la pression à l'intérieur du boîtier (3a) de sous-unité et la pression à l'intérieur du boîtier externe (1a).

11. Unité sous-marine (1A; 1B) selon l'une quelconque des revendications précédentes, le compensateur passif (3b) de pression de la première sous-unité (3G) et une paroi du boîtier (3a) de sous-unité étant définis par une partie du boîtier externe (1a) de l'unité sous-marine (1A; 1B), et la partie du boîtier externe (1a) présentant une épaisseur dotée d'une flexibilité mécanique telle qu'elle peut s'adapter à une différence de pression de 50 bar entre la pression à l'intérieur du boîtier (3a) de sous-unité et une pression sous-marine ambiante.

12. Unité sous-marine (1A; 1B) selon l'une quelconque des revendications 6 à 11, l'absorbeur (3g) en vrac comportant un matériau parmi un gel de silicone, du charbon actif et un matériau magnétique.

13. Système sous-marin de puissance comportant une unité sous-marine (1A; 1B) selon l'une quelconque des revendications 1 à 12.

14. Système sous-marin de puissance selon la revendication 13, le système sous-marin de puissance étant un système de transmission de puissance ou un système de distribution de puissance.
